Europäisches Patentamt

European Patent Office

Office européen des brevets

(19)

(11) **EP 1 187 219 A1**

(12) **EUROPEAN PATENT APPLICATION**

(43) Date of publication:
    **13.03.2002 Bulletin 2002/11**

(51) Int Cl.⁷: **H01L 29/76**, H01L 29/66,
    H01L 29/772

(21) Application number: **00307579.3**

(22) Date of filing: **01.09.2000**

(84) Designated Contracting States:
    **AT BE CH CY DE DK ES FI FR GB GR IE IT LI LU
    MC NL PT SE**
    Designated Extension States:
    **AL LT LV MK RO SI**

(71) Applicant: **BTG INTERNATIONAL LIMITED**
    **London EC4M 7SB (GB)**

(72) Inventors:
    • **XU, Hongqi**
      **S-224 74 Lund (SE)**

    • **WORSCHECH, Lukas, Maria Dietmar**
      **97082 Würzburg (DE)**
    • **SAMUELSON, Lars Ivar**
      **S-217 74 Malmö (SE)**
    • **FORCHEL, Alfred**
      **97074 Würzburg (DE)**

(74) Representative: **Buttrick, Richard**
    **BTG International Limited,**
    **10 Fleet Place**
    **London EC4M 7SB (GB)**

(54) **Ballistic electronic devices**

(57)    An electronic device of nanometric dimensions which exhibits non-linear transistor or rectifying action comprises a region (40) fabricated to provide ballistic transport properties for electron flow, with ballistic junctions (42, 44, 46) formed in region (40), each junction exhibiting quantum states with an associated electrochemical potential and a voltage dependent transmissivity. An alternating voltage may be applied across junctions (44, 46), and a rectified voltage is developed at junction (42). Alternatively, a constant voltage may be applied to terminal (44), to modulate the characteristics of electron flow through junctions (42, 46), in a transistor-like manner.

Figure 4B

**EP 1 187 219 A1**

Printed by Jouve, 75001 PARIS (FR)

**Description**

The present invention relates to electronic devices, employing the ballistic properties of electrons at small dimensions of the order of nanometers.

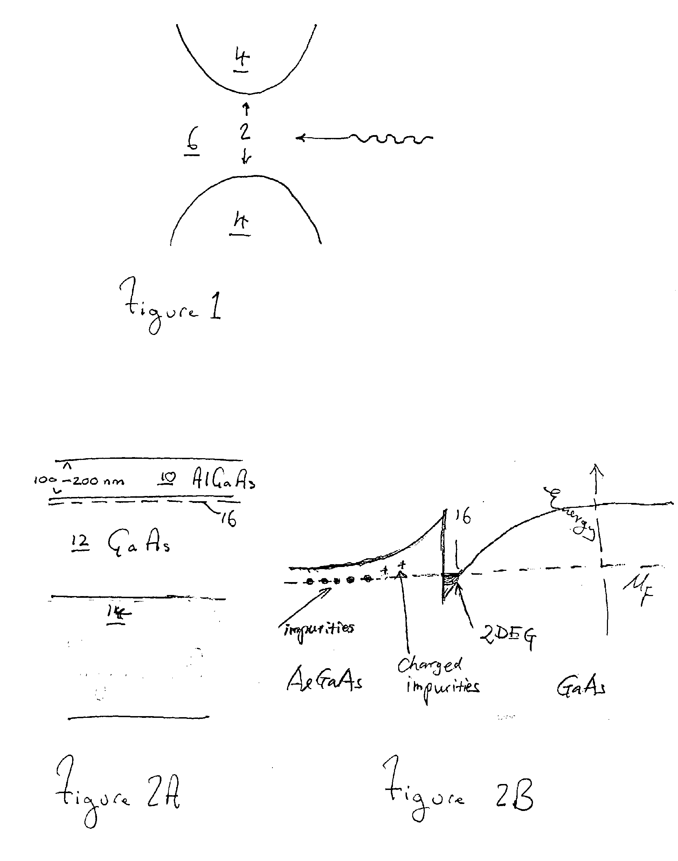

By way of background, it is well known that at atomic or molecular dimensions or nanometers (nm), the transport properties of electrons change remarkably. The so-called quantum point contact is of interest (see for example http://www.lorentz.leidenuniv.nl). A point contact is formed by simply pressing two metal parts together to permit current flow through the point contact thus formed. A quantum point contact is formed as a narrow constriction in a material, through which electrons may flow, the width of the constriction being comparable to the Fermi wavelength of the electrons in the material, and much less than their mean free path. In such a contact, quantum-mechanical effects are exhibited. For example, the quantum point contact shown in Figure 1 comprises a narrow constriction, or saddle point 2, of the order of 10nm wide between two smooth convex barriers 4. The barriers are formed in a region 6, in which the Fermi wavelength of the electrons is about 50 - 100 nm. The mean free path of the electrons is several microns at low temperature. One presentation of the theory of such devices is given in **Physical Review B 15 April 1990, 41, pages 7906 - 7909** " Quantised transmission of a saddle-point constriction"- M. Büttiker. In the region of the constriction, there are energy level states and/or sub-bands which an electron may occupy. Application of an electric voltage across the constriction changes the energy levels of the device. The conductance is shown to be a "stair case", with an approximately linear dependence on the applied voltage. The steps are multiples of $2e^2/h$. An explanation of this quantisation views the constriction as an electron waveguide, through which a small number of transverse modes or sub-bands can propagate at Fermi level. The wide regions at opposite sides of the constriction are reservoirs of electrons in local equilibrium. A voltage difference between the reservoirs induces a current through the constriction, distributed among the transverse modes or sub-bands, and the conductance value is obtained by summing over all occupied modes and sub-bands.

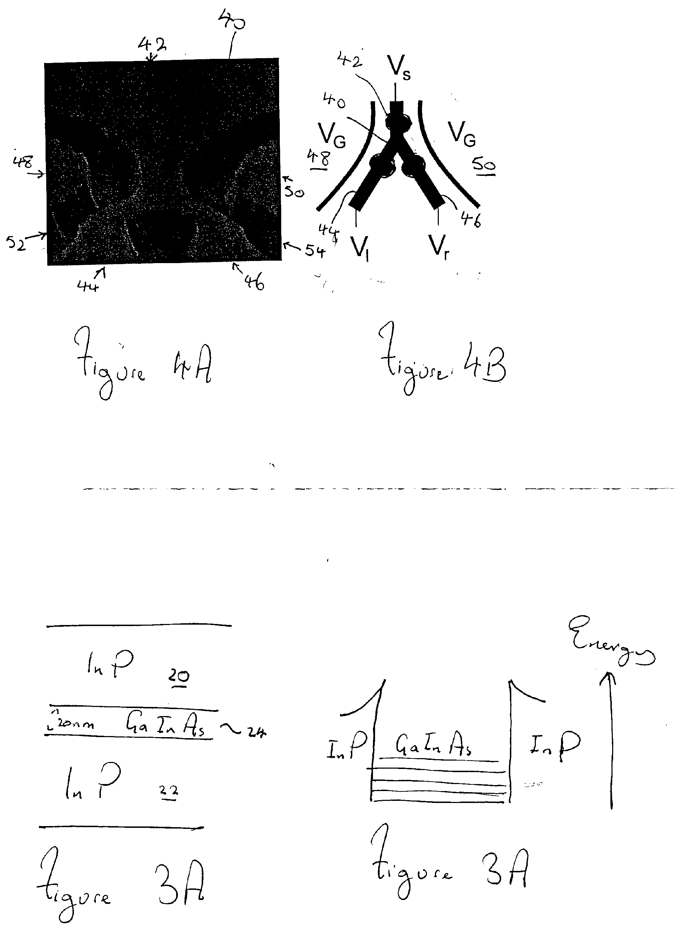

In order to achieve high electron mobility, without scattering, so that the electrons have a long mean free path, (i.e. the electrons may be regarded as ballistic in their flow paths), it is usual to form what is known as a two-dimensional electron gas (2DEG). One way of achieving this is shown in **Fig. 2A,** wherein a very thin layer, 100nm - 200nm, of AlGaAs 10, is formed on a layer 12 some microns thick, of GaAs, which is in turn formed on a substrate 14 of high purity. As shown in **Fig. 2B,** the energy levels for electrons have a dip or "well" at 16 at the boundary between the layers 10, 12. In this region, electrons have quantised energy states, along the direction of growth, and a very long mean free path in the plane of the layers, several microns long. This figure is applicable at temperatures close to absolute zero - as the temperature rises, so does the amount of phonon scattering, which reduces the mean free path.

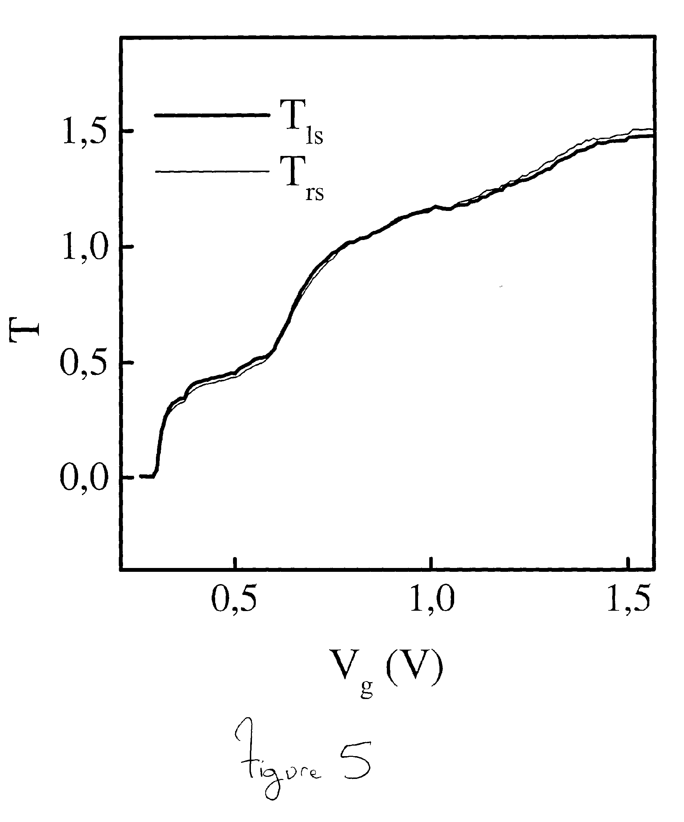

Another structure for achieving 2DEG is shown in **Figure 3A**, wherein layers 20, 22 on InP have formed between them a very thin layer 24 of GaInAs. This forms a quantum well device with energy levels as shown in **Figure 3B.** In the quantum well region 24 the electrons have long mean free paths - the precise value is highly dependent on the absolute temperature of the device.

The ballistic electron Y-branch switch (YBS) is a device in which an electric field can direct electrons injected from the stem of the Y into one of the two branches of the Y, while the other branch is cut off. The properties of YBS devices have been studied - see for example **Applied Physics Letters 60(2) 13 January 1992,** pages 237 - 239 "Analysis of an electron -wave Y- branch switch", Palm and Thylén, and **Volume 82, No. 12, 22 March 1999, Physical Review Letters** "Self-gating effect in the electron Y-branch switch", Wesström. In these reference, electrons flow through a conductive region in the form of a Y, through the base or stem of the Y, and are switched to flow in one or other of the arms of the Y, depending on the direction of a bias potential applied across the arms of the Y. This Y branch is considered as analogous to a linear optical waveguide device, and is analyzed as such.

**DE-A-19757525** discloses a rectifying arrangement comprising a triangular-shaped etching at the junction between collinear current flow paths such as to induce a rectified voltage in a path perpendicular to the current paths.

**SCIENCE, Volume 283, 19 March 1999 "An adiabatic quantum electron pump" Switkes et al,** reports a quantum pumping mechanism that produces DC current or voltage in response to a cyclic deformation of the confining potential in an open quantum dot.

**Summary of the Invention**

It is an object of the present invention to provide a novel electronic device, of nanometric dimensions.

In a first aspect, the invention provides an electronic device consisting of a region providing ballistic electron flow, and at least first, second and third ports providing electron flow paths to or from said region, at least one of the ports being such as to provide quantum states with associated energies for electrons in the region of the port, and means for applying a voltage to one or more of the ports, such as to modify the occupancy of said states by the electrons, whereby to provide a non-linear relationship between the electron flow through said ports and applied voltage.

Said region may consist of a small area forming a central junction between the electron flow paths. Alternatively the region may cover the entire device of the invention, the ports being formed by etching within the region or otherwise, to define the electron flow paths.

Accordingly, the invention provides in a second aspect an electronic device consisting of a region providing ballistic electron flow, and at least first, second and third interconnected ports for electron flow being provided in the region, at least one of the ports being such as to provide quantum states with associated energies for electrons in the region of the port, and means for applying a voltage to one or more of the ports, such as to modify the occupancy of said states by the electrons, whereby to provide a non-linear relationship between the electron flow through said ports and applied voltage.

Various other aspects of the invention are set forth in the appended claims.

As preferred both first and second ports, and, optionally said third port, are each such as to provide said quantum states.

In accordance with the invention, one or more of said ports may comprise quantum point contacts. Quantum point contacts are normally low temperature devices. However, the invention is applicable to any ballistic transport zone, at low temperature or at higher temperatures, in which a narrow electron flow path is provided, by a constriction or otherwise, and which flow path has associated quantum states (discrete states or a continuum of states), and/or a local reservoir of electrons in at least temporary equilibrium having a observable local Fermi level or local electro chemical potential. For the purposes of this specification, such a flow path will be termed a "ballistic junction".

As preferred where a ballistic junction is formed as a quantum point contact, it is defined by a constriction or saddle point in a path for electron flow. The constriction is formed by etching to provide smooth contours of a barrier wall. However other means of defining the constriction may be envisaged - for example, superimposed split gates providing electron depletion on either side of a flow path.

The theory of quantum point contacts shows that there are discrete quantum states in a direction transverse to the constriction, having a discrete quantum number and energy level. In a direction through the constriction, there is a continuum of states formed into sub-bands, each sub-band corresponding to a discrete transverse quantum number, which is often referred to as a transverse mode. Electrons in the region of the junction fill the states with lower energies so as to define a Fermi level (or electrochemical potential).

For elevated temperatures, electrons fill discrete energy level states or sub-bands with a probability determined by the Fermi-Dirac distribution.

External electrical contact is made to the ballistic junctions of the device of the invention by ohmic contacts, in per se known manner, to permit current flow and application of external voltage. The ohmic contact acts as a local reservoir for electrons. As explained above, a quantum point contact may be regarded as having reservoirs on either side of the constriction, each having its own local equilibrium. For the purposes of the present specification, the reservoir associated with the external electrical contact, usually the outer reservoir with respect to the electronic device, is the operative reservoir for the purposes of influencing the characteristics of the device. The current flow through a ballistic junction may also be controlled by side gates positioned close to the junction but electrically insulated from the junction.

Geometrically, the device may take many forms, the electron flow paths through the ballistic junctions extending from a central region at any desired angle to form devices having the form for example of a T, Y, $\in$ or arrowhead. One convenient shape described herein is a Y shape with a base (or stem) and branches (or arms); however the invention is not restricted to this particular geometry.

The device according to the invention will usually be formed of three ports; however for some applications more than three ports may be desired.

In accordance with the invention, it has been found that where a voltage is applied across two of the ballistic junctions such that electrons flow from one ballistic junction to the other, the electron flow will be influenced by a voltage applied to the third ballistic junction. The voltage at the third ballistic junction may be applied from an external source; alternatively the voltage may be induced from the voltages and electron flow between the other two junctions. Further, it has been found that the voltage at the third junction has a non-linear relation to the voltage across the other two ballistic junctions. Thus for a given voltage at one ballistic junction, and with a voltage across the other two ballistic junctions causing electron flow, there exists a non-linear relation between the two voltages. This non-linear relationship is essentially in two stages, firstly an initial linear relationship, followed by a saturation region. Such a characteristic is similar to a transistor characteristic.

In another mode of operation, it has been found that if an alternating voltage is applied across two of the ballistic junctions, then a unipolar voltage is induced at the third ballistic junction. In other words, the device acts as a rectifier.

These totally unexpected effects can be explained in accordance with the invention, as will become apparent in the description with reference to the drawings. Essentially, the transmissivity of a flow path in a ballistic junction is dependent on the voltage across the ballistic junction. Thus if a positive voltage is applied to one ballistic junction, the transmissivity will decrease, and if a negative voltage is applied to another ballistic junction, its transmissivity will increase. Negative current flow into the third ballistic junction will be determined by the ballistic junction with the higher transmissitivy. However the flow out of the third ballistic junction into the current path between the other two ballistic junctions will be determined by the ballistic junction with the lower transmissivity. Thus there is a net build-up of electrons in the third ballistic junction resulting from an alternating voltage applied across the other two ballistic junctions.

In a "transistor" mode of operation, one ballistic junction is held at a constant voltage, which implies a certain electrochemical potential and Fermi level. Thus, when current flow takes place between the other two ballistic junctions, this current flow will be influenced by the Fermi level at the third ballistic junction. Initially, the third ballistic junction has little effect on the current flow between the other two ballistic junctions, for low voltages at the other two ballistic junctions. This will result in an approximately linear increase of the voltage at the second ballistic junction as the voltage at the first ballistic junction rises. However, when the voltages at the first and second ballistic junctions reach such a level that the associated Fermi levels approach that in the third ballistic junction, then the third ballistic junction becomes a net supplier of electrons to the current flow, and the voltage at the second ballistic junction tends to remain constant for rising voltage at the first ballistic junction.

It will be understood that the effect of the present invention cannot be understood in terms of analogues to linear optical waveguides, which is an approach that has been used in the past.

The device of the invention may be employed to generate second or higher order harmonic oscillations from an applied frequency, or double or higher order multiplication of frequencies.

The device of the invention may be employed to achieve logical AND or OR functions.

Thus, in a further aspect, the invention provides an electronic device consisting of a region providing ballistic electron flow, and at least first, second and third interconnected ports for electron flow being provided in the region which are such that there exists for each flow path a reservoir of electrons in at least temporarily local equilibrium defining a local electrochemical potential, and means for applying a voltage across at least one of the ports whereby the value of conductance through the port is a function of the applied voltage, whereby a non-linear relationship between the electron flow through said interconnected ports is provided.

As preferred, at least two of the ports have means for applying a voltage thereto, the third port having means for monitoring a voltage created at the port.

Accordingly, there is provided in a further more specific aspect, an electronic device consisting of a region providing ballistic electron flow, and at least first, second and third interconnected ports for electron flow being provided in the region which are such that there exists for each flow path a reservoir of electron in at least temporary local equilibrium defining a local electrochemical potential, and means for applying first and second voltages to said first and second ports, whereby the conductance value for electron flow through each of the first and second ports is dependent upon the applied voltage, whereby to create a non-linear rectifying or amplifying action between electron flow through said interconnected ports by appropriate manipulation of the applied voltages to the first and second ports.

In another preferred form of the invention, a 2DEG region provides a current flow path between first and second ballistic junctions. This current flow path may be essentially straight. A conductive region extends from the flow path between the two ballistic junctions to define a stem or spur, in which a voltage is induced. This stem or spur may be used as a control electrode to control another mechanism, for example it may project towards the path of electron flow in an electron waveguide, in order to control current flow therein, and thereby achieve amplification.

**Brief Description of the Drawings**

Preferred embodiments of the invention will now be described with reference to the accompanying drawings, wherein:

**Figure 1** is a schematic view of a known quantum point contact formed by a saddle point constriction, for use in explaining the present invention;

**Figures 2A and 2B** schematic views of the construction and energy characteristics of a known heterostructure providing a 2DEG;

**Figures 3A and 3B** are a sectional constructional view and an energy diagram of a known quantum well structure for providing 2DEG;

**Figures 4A and 4B** is a plan view of a first embodiment of the present invention comprising a scanning electron micrograph of the center section of an electron device comprising three ballistic junctions, and a schematic view thereof;

**Figure 5** comprises transmission traces associated with electrons passing the ballistic junctions of the embodiment of Figure 4;

**Figure 6** is a graph showing measured voltage at the third ballistic junction of Figure 4 as a function of the voltage applied to the left ballistic junction, with the voltage at the right ballistic junction being varied in a push- pull fashion;

**Figure 7** is a graph of the voltage output from the third ballistic junction versus the voltage applied to the left ballistic junction, these values being calculated values to show the correspondence between experiment and theory;

**Figure 8** is a plan view of a second embodiment of the present invention comprising a scanning electron micrograph of the center section of an electron device;

**Figure 9 and 10** are graphs, for the first embodiment of Figure 4, of the calculated voltage relationship between the first and third ballistic junctions for current flow therebetween, with various voltages applied to the second ballistic junction; and

**Figure 11** is a graph, corresponding to those of Figures 9 and 10, showing the calculated voltage relationship between the first and third ballistic junction for current flow therebetween, with a constant voltage applied to the second ballistic junction, for various values of the Fermi potential, or electrochemical potential.

**Description of the Preferred Embodiment**

In a preferred embodiment of the invention, an electronic device operates in a non-linear response regime. The device is made from high mobility GaAs/AlGaAs heterostructures. Three interconnected ballistic junctions are formed in a region of high mobility, providing a 2DEG. The device defines a geometric Y form having left and right branches and a stem. When finite voltages $V_\ell$ and $V_r$, are applied to the left and right branches in push pull fashion ($V_\ell = -V_r$), while keeping the stem ballistic junction floating, the measured voltage $V_s$ of the stem ballistic junction will always be negative. This result is unexpected for the known symmetric YBS made from classical conductors, for which Ohm's law implies a zero output, $V_s = 0$, from the stem.

It will be understood that in the region of a ballistic junction there is formed a <u>reservoir</u> of electrons in local equilibrium. Each reservoir has a respective local Fermi level and respective electrochemical potential $\mu_F$. Where an ohmic contact is made to the ballistic junction, the electrochemical potential $\mu_F$ will be defined as that existing at the ohmic contact.

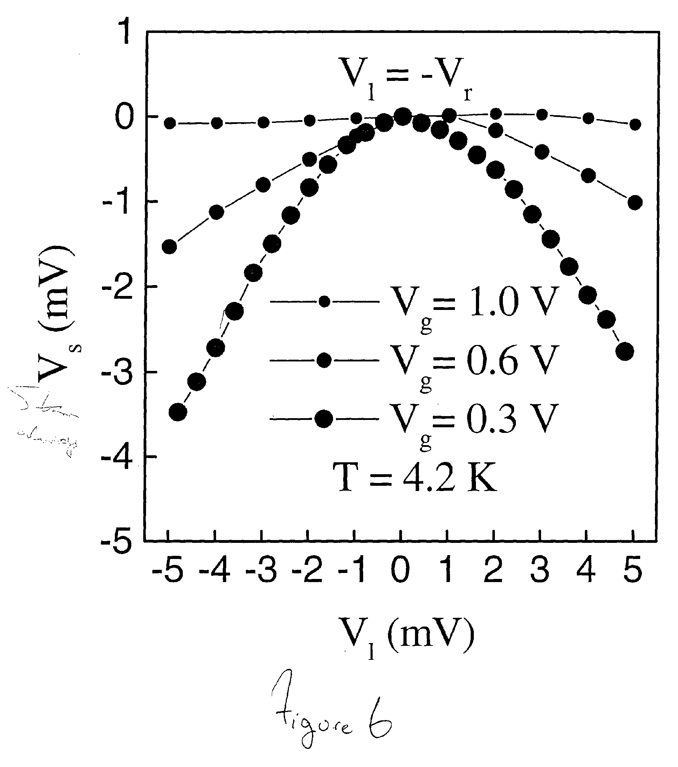

FIG. 4A is a scanning electron micrograph of a region 40 of an electron device fabricated by electron beam lithography and wet chemical etching from a modulation doped GaAs/AlGaAs heterostructure. The region 40 has ballistic transport properties for electron flow, with a mean free path much greater than the width of the region. Ballistic junctions 42, 44, 46 are formed in region 40 and each has a lithographically-defined width of 180 nm and a length of 100 nm. The electron flow paths through the junction 42, 44, 46 interconnect to form a Y-shape. The junction forming stem 42 at the centre is connected with the left 44 and right 46 junctions forming branches at the bottom of the figure. On the left and right side, two side gates 48, 50 are provided, to which gate voltages are applied. Fig 4B is a schematic layout of Fig 4A. The left and right junctions 44, 46 are biased in push pull fashion by voltages $V_\ell$, $V_r$ where the sidegates 48, 50 are used to control the depletion in the branches. Ohmic contacts (not shown) connect voltages $V_\ell$, $V_r$ to junctions 44, 46. An ohmic contact is also made to junction 42.

The device is fabricated from modulation doped GaAs/AlGaAs heterostructures with a two-dimensional electron gas located 80 nm below the surface. On the unprocessed wafer, the carrier density and the mobility determined at 4.2 K are about 3.7 x $10^{11}$ cm$^{-2}$ and 2 x $10^6$ cm$^2$/Vs, respectively. The lithographically-defined geometrical width of the electron paths is 180 nm and the length of each branch 100 nm. The angle between the two Y-branched paths is about 60°. Electron beam lithography and wet chemical etching was performed to fabricate 180 nm wide and 100 nm deep trenches 52, 54 to isolate the 2DEG in the side gates 48, 50 from the electrons in the paths 42, 44, 46.

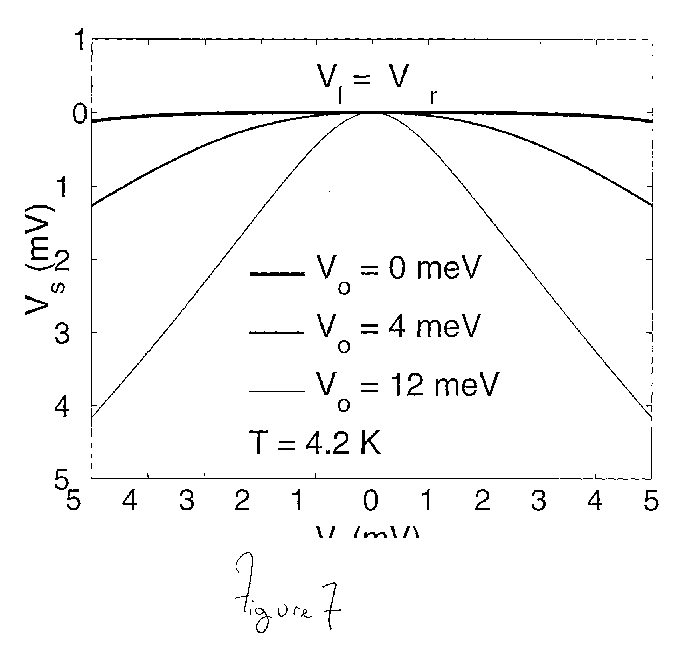

Figure 5 shows the transmission traces of the device, measured using standard lock-in techniques, between the stem and the left reservoir ($T_{\ell s}$) associated with ballistic junctions 42 and 44 and between the stem and the right reservoir ($T_{rs}$) associated with ballistic junctions 42 and 46, versus voltage Vg applied to the side gates. The contacts to the side gates are ohmic. Thus the voltage at the side gates is sensed by a voltmeter in the voltage source connected to the side gates. It can be seen that the device does not show conduction between the stem reservoir and the two branch reservoirs until the voltage applied to the side gates is higher than a positive threshold of $V_{th}$ = 0.28 V. This is due to the fact that the etching process introduces surface states on the side walls, leading to strong depletion around the structure. Conductance quantization is clearly seen in the measured transmissions $T_{rs}$ and $T_{\ell s}$. Figure 5 also shows that the two transmission traces, $T_{\ell s}$ and $T_{rs}$ can hardly be distinguished, which indicates that the device is almost perfectly symmetric with respect to the stem. The fact that the first plateaus in the transmissions $T_{\ell s}$ and $T_{rs}$ appear at a value of 1/2 is not due to the lift of spin degeneracy. This plateau is a consequence of a perfect adiabatic, ballistic process of the electron transport from the stem to the two branches. For a symmetric, ballistic device with adiabatic boundaries, the transmissions between the stem reservoir and the two branch reservoirs are determined solely by the conductance of the stem , $G_s$, via the relation of $T_{rs}$ = $T_{\ell s}$ = ($h/4e^2$)$G_s$, the two branches being wide enough to receive electrons injected from the stem reservoir.

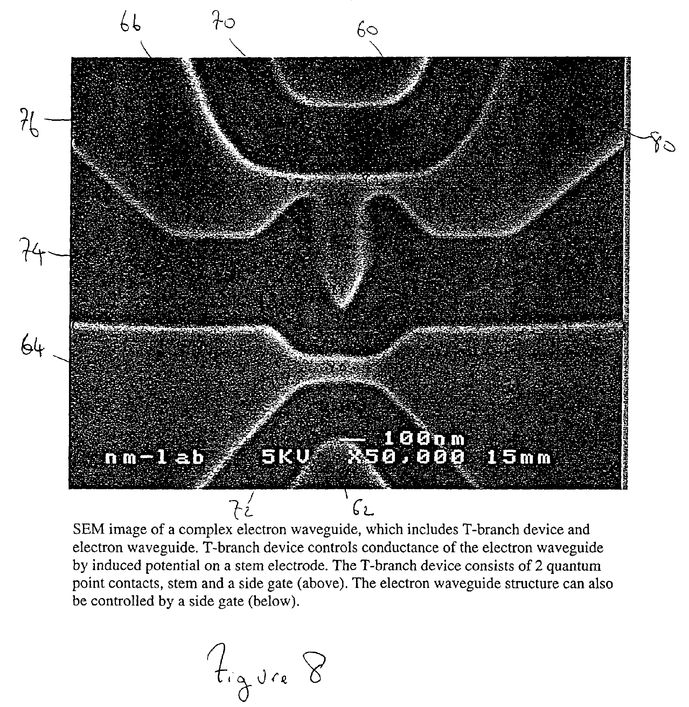

As shown in figure 4, voltage connections are made to the left and right branch reservoirs with differences in the electrochemical potential, while the voltage output from the floating stem reservoir is measured via respective ohmic contacts. The results are shown in figure 6, where the measured voltage of the stem reservoir $V_s$ has been plotted versus the voltage applied to the left reservoir $V_\ell$ of the device. The voltage of the right electron reservoir is $V_r$ = - $V_\ell$, i.e., the voltages are applied to the left and right branch in a push-pull fashion. The measured curves look approximately symmetric with respect to $V_\ell$ = 0. For a gate voltage of 1 V, $V_s$ is close to zero up to $|V_\ell| \leq 5$ mV. When the gate voltage is decreased to $V_g$ = 0.6 V, $V_s$ is seen to show a quadratic dependence on $V_\ell$ for small values of $|V_\ell|$ and to have negative values at both positive $V_\ell$ and negative $V_\ell$. For a gate voltage of $V_g$ = 0.3 V, for which the device is close to pinch off (see Fig. 6), a quadratic behaviour of $V_s$ versus $V_\ell$ with an even larger negative curvature is found.

These measurements show clearly that when finite voltages are applied to a symmetric, ballistic device in a push-pull fashion, the output stem voltage $V_s$ will always be negative. We note that this effect is observable not only in the low voltage region, but also in the region where high voltages are applied. The different gate voltages applied are associated with chemical potentials close to the pinch off (0.3V), one (0.6V) and two sub-bands (1V) occupied in the stem of the device. This effect contradicts Ohm's law applied to the device. This novel property does not appear in the linear response regime of electron transport, and that it is not observable if the device is constructed from classical, diffusive conductors.

To study the physical origin of the novel effect, we have carried out model calculations for the device as shown in Fig. 4, based on the concept of a non-linear response for a ballistic, three-terminal junction. In the calculations, three ballistic junctions were each described by a saddle-point potential of the form $V(x, y) = V_0 - \frac{1}{2} m^* w^2 x^2 + \frac{1}{2} m^* w^2 y^2$ where $V_O$ is the electrostatic potential at the saddle, m* is the electron effective mass, x and y define the co-ordinate along and perpendicular to the transport direction, respectively. Since the measured devices were made by etching, resulting in strong confinement in the ballistic junction, the application of a voltage on the side gates does not change the shape of the confinement potential, but rather the potential $V_O$ at the saddle. The parameters $\hbar w_x = 6$ meV and $\hbar w_y = 15$ meV were used for the three ballistic junctions and were independent of the side gate voltage. However, several values of $V_O$ were used in order to simulate a situation where different voltages were applied to the side gates. The Fermi energy was taken to be $\mu_F = 14$ meV, corresponding to an electron density of $3.9 \times 10^{11}$ cm$^{-2}$ in the 2DEG region. When voltages $V_\ell$ and $V_r$ are applied to the left and right branch reservoir, the electrochemical potentials in the two reservoirs shift to

$$\mu_\ell = -eV_\ell + \mu_F \text{ and } \mu_r = -eV_r + \mu_F$$

respectively. The electrochemical potential in the floating stem reservoir $\mu_s$ is determined by the condition that the current at the stem reservoir $I_s = 0$, while the output voltage from the stem reservoir is given by $V_s = -(\mu_s - \mu_F)/e$. For a symmetric, ballistic device, the electron transmissions $T_{\ell s}$ and $T_{rs}$ depend only on the conductance of the stem . Thus, the functional characteristics of $V_s$ versus $V_\ell$ are determined mainly by the behaviour of the conductance of the stem whereas the detailed layout of the YBS structure is not important.

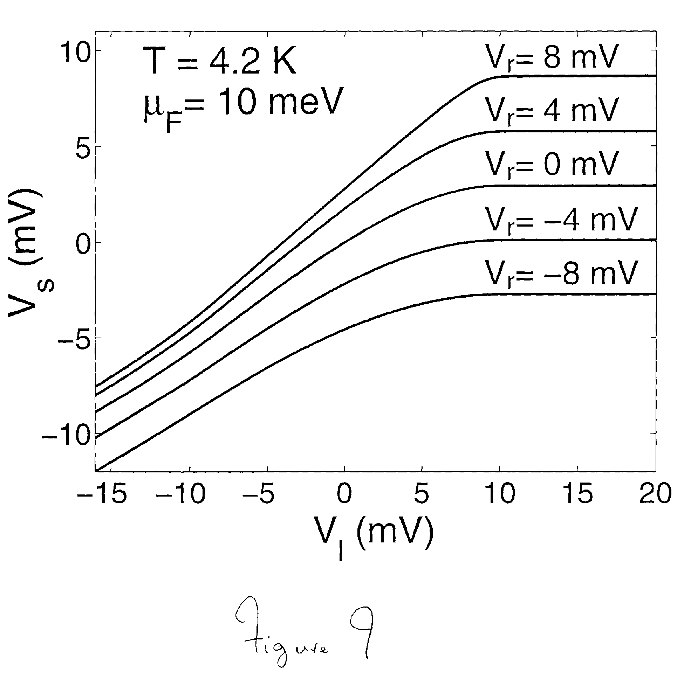

Figure 7 shows the results of the calculations for the present device operated in a push-pull fashion, $V_\ell = -V_r$. The calculated $V_s$ have been plotted versus $V_\ell$ for three values of the potential at the saddle $V_0$.. For $V_o = 0$ meV, the transmissions $T_{\ell s}$ and $T_{rs}$ at the energy of $\mu_F = 14$ meV, are on a plateau. This is the situation corresponding to a voltage of 1.0 V being applied to the side gates. Thus, the current flow between the left branch and the stem reservoir depends, approximately, linearly on the difference in the electrochemical potential between the two reservoirs. The same holds also for the current flow between the right branch and the stem reservoir. The system behaves, therefore, like a three-terminal device built from linear conductors, where Ohm's law is applicable. As a result, for the device operated in the push-pull fashion the output voltage $V_s$ should approximately stay at zero at small values of $|V_\ell|$ as shown in the top curve of Fig. 6. For the case of $V_o = 4$ meV, corresponding to the of $V_g = 0.6$ V (see Fig. 5), the transmissions $T_{\ell s}$ and $T_{rs}$ at the energy of $\mu_F = 14$ meV, are between values described by plateaux. The negative current flow into the stem reservoir which occurs for an increase, $e |V_\ell|$, in the electrochemical potential in the either of the two branch reservoirs with respect to the potential of the stem reservoir, is always larger than the negative current flow out of the stem reservoir, for the same small amount of the decrease in the electrochemical potential in the other branch reservoir. To establish the current balance in the floating stem ($I_s = 0$), the electrochemical potential $\mu_s$ has to increase to a value between $\mu_F$ and $\mu_F + e|V_\ell|$. Thus, the measured output voltage from the stem reservoir is seen to be always negative, as was shown in the middle curve of Fig. 6. In addition, the calculated $V_s$ shows a good quadratic dependence on $V_\ell$ for small $|V_\ell|$. For the case of $V_o = 12$ meV, the transmissions $T_{\ell s}$ and $T_{rs}$ at the energy of $\mu_F = 14$ meV are close to be pinched off, as in the experiment at $V_g = 0.3$ V (see Fig. 2). The output stem voltage $V_s$ remains negative for all finite values of $V_\ell$, which is the same as in the calculation for $V_o = 4$ meV. However, compared with that calculation, relatively larger negative output voltage $V_s$ at a given finite $V_\ell$ is found, in agreement with the experiment. All these features can be understood similarly as for the calculation for the case of $V_O = 4$ meV.

Experimental observations are well explained by the model based on three coupled quantum point contacts. The good agreement between theory and experiment shows that the experimentally observed novel effect is an intrinsic property of three-terminal ballistic junctions in a non-linear response regime. The calculations also indicate that the novel effect will be observable as long as the conductance of the three conductors, of which a three-terminal junction is composed, increases with the electrochemical potential provided the size of the central part of the device is smaller than the mean free path of the electrons. Thus, according to the theoretical model one can expect to observe this novel effect also at room temperature, since it is possible, with today's nanofabrication technology, to make such devices with dimensions of the order of 100 nm or below, comparable to the mean free path of high mobility materials at room temperature.

The present invention provides a novel property in a GaAs/A1GaAs ballistic Y-branched device. When two voltages are applied to the left and right branch reservoirs, the electrochemical potential of the floating stem reservoir tends to take the higher value of the electrochemical potentials in the two branch reservoirs. Thus, for a symmetric device with voltages being applied in the push-pull fashion to the two branch reservoirs, the output voltage from the stem reservoir will always be negative, in disagreement to the prediction of Ohm's law. The novel effect is confirmed by calculations based on a non-linear response theory of electron transport. The existence of ballistic transport in the device is found to be the precondition of the observed effect. It is predicted that the novel phenomena observed is universal for nanometer-scaled devices. Implications of feature-downscaled Si technology suggests a basis for extremely compact devices and circuits based on this type of behaviour.

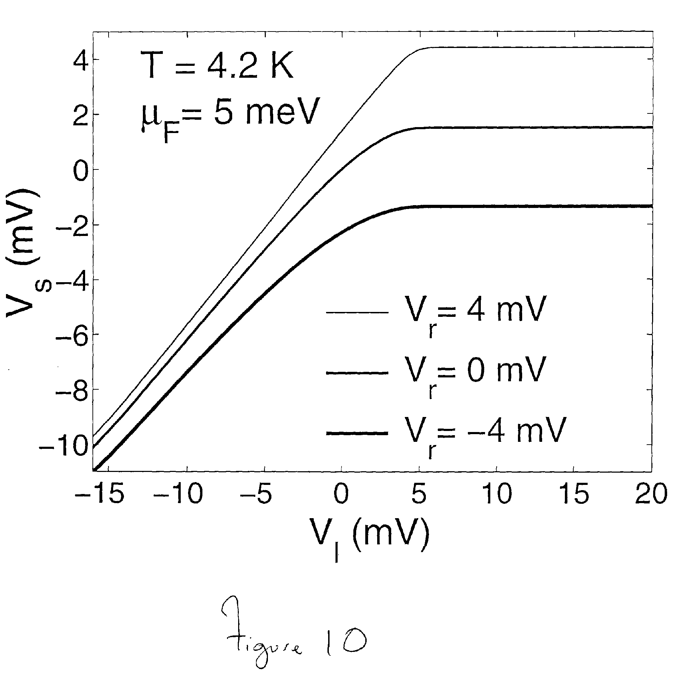

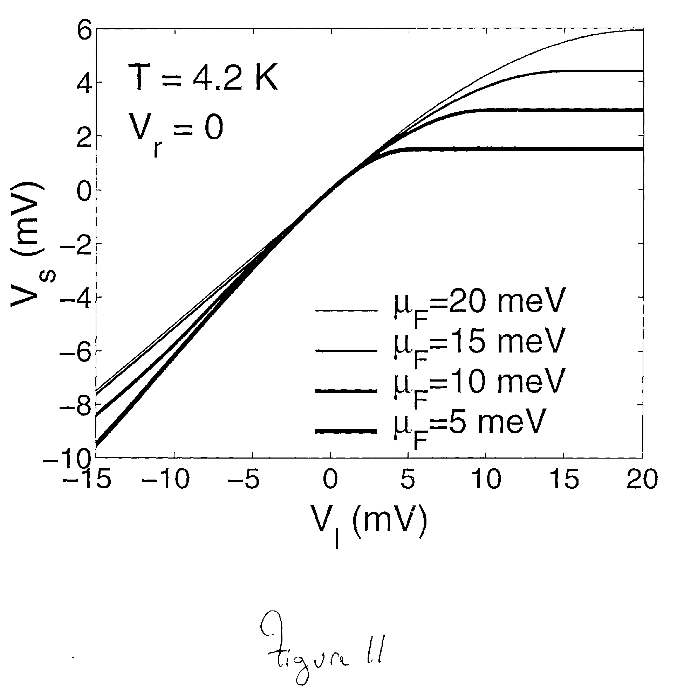

It is possible to operate the first embodiment in a transistor-like mode, as indicated by the graphs in figures 9, 10 and 11.

Figure 9 is graph for an absolute temperature of 4.2° Kelvin with the region 40 having a Fermi level of 10 meV. Figure 10 is a similar graph for an operating temperature of 4.2° Kelvin with a Fermi level of 5 meV.

In this mode of operation, the voltage at the right ballistic junction 46 is held constant at a given value and the voltage relation between the contacts that connect ballistic junctions 42, 44 are shown. It may be seen for any given value of $V_r$, the relationship between $V_\ell$ and $V_s$ is non-linear, having an approximately linear relation for negative values of $V_\ell$ and $V_s$, and a saturated region for positive values of $V_\ell$ in which $V_s$ remains constant. It may be seen that as the voltage $V_r$ is changed, the relationship between $V_\ell$ and $V_s$ remains essentially the same but the precise values change so that the saturation voltage of $V_s$ is much higher at positive value of $V_r$ than for negative values of $V_r$. It may be seen that this produces essentially a family of transistor-like curves, and shows that the device may operate as a transistor with a modulating voltage being applied to ballistic junction 46 as voltage $V_r$.

Figure 11, is a calculated value of the relationship between $V_s$ and $V_\ell$ for various values of Fermi level, with Vr being held at 0 volts.

Referring now to Figure 8, there is shown a second embodiment of the invention configured as a transistor. The device comprises conductive regions 60, 62, 64 and 66 separated by etched isolating regions 70, 72, 74. These etched isolated regions may be filled with an insulating material.

Conductive region 66 is, in this example, generally T-shaped and a left arm 76 narrows to form a ballistic junction 78. The right arm 80 narrows to form a second ballistic junction 82. Between ballistic junctions 78, 82 is a region 84 providing ballistic transport of electrons, with a mean free path far greater than the width of region 84. A spur or branch 86 extends from region 84 with a pointed end 88. Branch 86 has a reservoir of electrons in local equilibrium with an associated electrochemical potential.

Conductive region 64 narrows at its central area to define a ballistic junction 90. Conductive region 60, 62 provide gates for applying control voltages.

In operation, electron flow through ballistic junction 78, 82 and zone 84, induces a voltage in spur 86 and its pointed end 88. This voltage modulates, by depletion, the flow of electrons in conductive regions 64 through ballistic junction 90. Thus a transistor-like action is provided, giving a function of amplification of electron flow in junctions 78, 84 in the electron flow through junction 90.

## Claims

1. An electronic device consisting of a region providing ballistic electron flow, and at least first, second and third ports providing electron flow paths to or from said region, at least one of the ports being such as to provide quantum states with associated energies for electrons in the region of the port, and means for applying a voltage to one or more of the ports, such as to modify the occupancy of said states by the electrons, whereby to provide a non-linear relationship between the electron flow through said ports and applied voltage.

2. An electronic device consisting of a region providing ballistic electron flow, and at least first, second and third interconnected ports for electron flow being provided in the region, at least one of the ports being such as to provide quantum states with associated energies for electrons in the region of the port, and means for applying a voltage to one or more of the ports, such as to modify the occupancy of said states by the electrons, whereby to provide a non-linear relationship between the electron flow through said ports and applied voltage.

3. A device according to claim 1 or 2, wherein at least said first and second ports are each such as to provide said quantum states.

4. A device according to claim 3, wherein each of said first, second and third ports is such as to provide said quantum states.

5. A device according to any preceding claim, wherein electrons fill quantum states with lower energy such as to define a local Fermi level, the quantum states comprising discrete energy level states and/or subbands.

6. A device according to any preceding claim, wherein the quantum states comprise discrete energy level states and/or sub-bands with a certain probability of occupancy by electrons, and said means for applying a voltage is such as to modify said probability of occupancy and to create a voltage dependent transmissivity in the respective port.

7. An electronic device consisting of a region providing ballistic electron flow, and at least first, second and third ports providing electron flow paths to or from said region, the ports being such that there exists for each flow path a reservoir of electrons in at least temporary local equilibrium defining a local electrochemical potential, and means for applying a voltage to one or more of the ports, such as to modify the value of the respective electrochemical potentials, whereby to provide a non-linear relationship between the electron flow through said ports and applied voltage.

8. An electronic device consisting of a region providing ballistic electron flow, and at least first, second and third interconnected ports for electron flow being provided in the region which are such that there exists for each flow path a reservoir of electrons in at least temporary local equilibrium defining a local electrochemical potential, and means for applying a voltage to one or more of the ports, such as to modify the value of the respective electrochemical potentials, whereby to provide a non-linear relationship between the electron flow through said ports and applied voltage.

9. An electronic device consisting of a region providing ballistic electron flow, and at least first, second and third ports providing electron flow paths to or from said region, at least one port being such as to provide quantum states with associated energies and with a certain probability of occupancy by electrons, and means for applying a voltage to one or more of the ports, such as to modify said probability of occupancy and to create a voltage dependent transmissivity, whereby to provide a non-linear relationship between the electron flow through said ports and applied voltage.

10. An electronic device consisting of a region providing ballistic electron flow, and at least first, second and third interconnected ports for electron flow being provided in the region, at least one port being such as to provide quantum states with associated energies and with a certain probability of occupancy by electrons, and means for applying a voltage to one or more of the ports, such as to modify said probability of occupancy and to create a voltage dependent transmissivity, whereby to provide a non-linear relationship between the electron flow through said ports and applied voltage.

11. A device according to claim 9 or 10, wherein at least said first and second ports are each such as to provide said quantum states.

12. A device according to claim 11, wherein each of said first, second and third ports is such as to provide said quantum states.

13. An electronic device according to any preceding claim, wherein said at least one port is defined by a quantum point contact.

14. An electronic device according to any preceding claim, wherein the third port is defined by a narrow stem or spur.

15. An electronic device according to claim 14, wherein the stem or spur is disposed in proximity to a further ballistic junction in a further electron flow path, in order to influence the conduction of electrons in the further flow path, whereby to achieve amplification.

16. An electronic device according to any preceding claim, wherein at least one of the ports is formed by etching in said region.

17. An electronic device according to any preceding claim, wherein at least one of the ports has a respective ohmic contact for conducting electrons and for applying external voltages.

18. An electronic device according to any preceding claim, including means for monitoring a voltage developed at at least one port.

19. An electronic device according to claim 18, wherein the means for monitoring a voltage includes side-gates, disposed to the sides of the electron flow paths.

20. An electronic device according to any preceding claim, including means for applying an alternating voltage across the first and second ports, and means for monitoring a rectified voltage at the third port.

21. An electronic device according to any of claims 1 to 19, including means for applying a voltage at the second port, and means for monitoring the voltages developed at the first and third ports in response to electron flow there through.

22. An electronic device consisting of a region providing ballistic electron flow, and at least first, second and third interconnected ports for electron flow being provided in the region which are such that there exists for each flow path a reservoir of electrons in at least temporarily local equilibrium defining a local electrochemical potential, and means for applying a voltage across at least one of the ports whereby the value of conductance through the port is a function of the applied voltage, whereby a non-linear relationship between the electron flow through said interconnected ports is provided.

23. An electronic device consisting of a region providing ballistic electron flow, and at least first, second and third interconnected ports for electron flow being provided in the region which are such that there exists for each flow path a reservoir of electrons in at least temporary local equilibrium defining a local electrochemical potential, and means for applying first and second voltages to said first and second ports, whereby the conductance value for electron flow through each of the first and second ports is dependent upon the applied voltage, whereby to create a non-linear rectifying or transistor action between electron flow through said interconnected ports by appropriate manipulation of the applied voltages to the first and second ports.

24. A method of achieving transistor action in an electronic device, the method comprising, providing a region having ballistic transport properties for electron flow, providing first, second and third ports in said region which provide electron flow to and from said region, at least one of the ports being such as to provide quantum states with associated energies for electrons in the region of the port, and applying a voltage to one of the ports in order to modulate the characteristics of electron flow through the other two ports in a non-linear manner.

25. A method of rectifying an alternating voltage, comprising providing a region having ballistic transport properties for electron flow, and providing first, second and third ports for electron flow to and from said region, at least one of the ports being such as to provide quantum states with associated energies for electrons in the region of the port, and applying an alternating voltage across two of the ports, and deriving a rectified voltage from the third port.

26. An electronic device according to any of claims 1 to 23, wherein the first, second and third ports are connected so as to provide a logical AND or OR function.

27. An electronic device according to any of claims 1 to 23, wherein the first, second and third ports are connected to receive an alternating voltage of a certain frequency across one or more of the ports, and to generate harmonics of the frequency at one or more further ports of the device.

Figure 1

Figure 2A

Figure 2B

Figure 4A

Figure 4B

Figure 3A

Figure 3A

Figure 5

figure 6

Figure 7

SEM image of a complex electron waveguide, which includes T-branch device and electron waveguide. T-branch device controls conductance of the electron waveguide by induced potential on a stem electrode. The T-branch device consists of 2 quantum point contacts, stem and a side gate (above). The electron waveguide structure can also be controlled by a side gate (below).

Figure 8

Figure 9

Figure 10

Figure 11

**European Patent Office**

## EUROPEAN SEARCH REPORT

Application Number

EP 00 30 7579

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 369 288 A (USUKI TATSUYA) 29 November 1994 (1994-11-29) | 1-15, 17-27 | H01L29/76 H01L29/66 |
| A | * figures 1A-1C * | 16 | H01L29/772 |
| X | US 5 270 557 A (SCHMIDT POUL E) 14 December 1993 (1993-12-14) * figure 2C * | 1-15, 18-27 | |
| X | EP 0 461 867 A (FUJITSU LTD) 18 December 1991 (1991-12-18) * figure 4 * | 1-15, 17-27 | |
| X | EP 0 626 730 A (HITACHI EUROP LTD) 30 November 1994 (1994-11-30) * figure 1 * | 1-15, 17-27 | |
| D,A | DE 197 57 525 A (LORKE AXEL DR) 1 July 1999 (1999-07-01) * figures 1,2 * | 1-17 | |

TECHNICAL FIELDS SEARCHED (Int.Cl.7)

H01L

The present search report has been drawn up for all claims

| Place of search | Date of completion of the search | Examiner |
|---|---|---|
| BERLIN | 17 January 2001 | Juhl, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.** EP 00 30 7579

This annex lists the patent family members relating to the patent documents cited in the above-mentioned European search report.
The members are as contained in the European Patent Office EDP file on
The European Patent Office is in no way liable for these particulars which are merely given for the purpose of information.

17-01-2001

| Patent document cited in search report | | Publication date | Patent family member(s) | | Publication date |
|---|---|---|---|---|---|
| US 5369288 | A | 29-11-1994 | JP | 5315598 A | 26-11-1993 |
| US 5270557 | A | 14-12-1993 | JP | 4011784 A | 16-01-1992 |
| EP 0461867 | A | 18-12-1991 | JP | 4229656 A | 19-08-1992 |
| EP 0626730 | A | 30-11-1994 | US | 5485018 A | 16-01-1996 |
| DE 19757525 | A | 01-07-1999 | NONE | | |

EPO FORM P0459

For more details about this annex : see Official Journal of the European Patent Office, No. 12/82